# EUROPEAN PATENT APPLICATION

(11) **EP 0 843 028 A1**
(43) Date of publication of application: **20.05.1998**
(21) Application number: 97119796.7
(22) Date of filing: 12.11.1997
(51) Int. Cl.: C30B 15/30

(54) **Magnetic-field applied czochralski crystal growth system**

(30) Priority: 14.11.1996 JP 302966/96
(71) Applicant: KABUSHIKI KAISHA TOSHIBA, Kawasaki-shi (JP)
(72) Inventor: Sasaki, Takashi, 1-1 Shibaura 1-chome Minato-ku Tokyo 105 (JP); Koguchi, Yoshihiro, 1-1 Shibaura 1-chome Minato-ku Tokyo 105 (JP)
(74) Representative: Henkel, Feiler, Hänzel

(57) **Abstract**

A magnetic-field applied Czochralski crystal growth system comprising at least one growing furnace (80) for containing molten semiconductor material, a pulling device for pulling a crystal from the molten semiconductor material in a predetermined direction, and a magnetic field generator (70A, 70B, 70C; 70A', 70B') for generating a magnetic field to be applied to the molten semiconductor material. The magnetic field generator comprises a plurality of magnet units (70A, 70B, 70C; 70A', 70B') and a coupling mechanism (90) coupling the magnet units (70A, 70B, 70C; 70A', 70B') together such that the growing furnace (80) is located between said magnet units (70A, 70B, 70C; 70A', 70B').

## Description

This invention relates to a Czochralski crystal growth system which is one of the systems for manufacturing a crystal ingot for use in manufacturing semiconductor wafers or the like. Particularly, it relates to a magnetic-field applied Czochralski crystal growth system in which a magnetic field is applied to molten semiconductor material.

A magnetic-field applied Czochralski crystal growth system (hereinafter referred to as "MCZ system") is one of crystal growth systems. In the MCZ system, a magnetic field is applied to the molten semiconductor material, thus controlling the heat convection in the molten semiconductor material. The MCZ system can therefore manufacture high-quality crystal ingots having a large diameter.

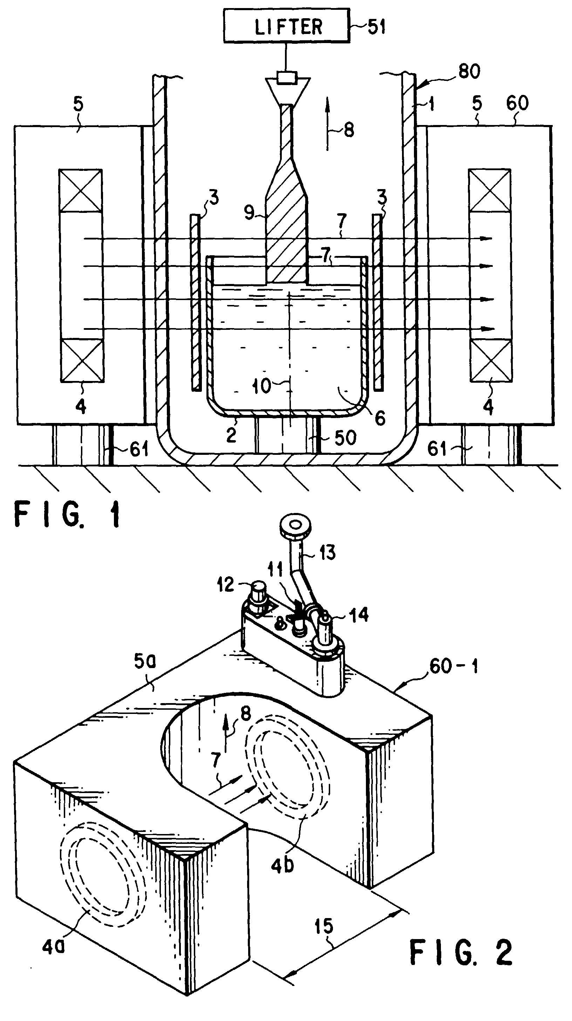

FIG. 1 shows a conventional MCZ system. This MCZ system comprises a magnetic field generator 60 and a growing furnace 80. Semiconductor material is melted in the growing furnace 80, so that a crystal may be pulled upwards from the molten semiconductor material. The magnetic field generator 60 generates a magnetic field. The magnetic field is applied to the molten semiconductor material in the growing furnace 80.

The growing furnace 80 includes a furnace body 1, a crucible 2, a heater 3, a crucible support mechanism 50, and a lifter 51. The crucible 2 is provided in the furnace body 1, for containing the semiconductor material. The heater 3 heats the material 6 in the crucible 2 to melt the material. The mechanism 50 supports the crucible 2. The lifter 51 is designed to pull up a crystal from the molten material 6 in the crucible 2. The mechanism 50 and the lifter 51 rotate relative to each other, whereby the crystal and crucible 2 are rotated relative to each other. The magnetic field generator 60 is mounted on a support 61 and surrounds the furnace body 1. The generator 60 contains a cryostat 5 which has a built-in superconductive coil 3.

How a crystal ingot is made in the MCZ system shown in FIG. 1 will be explained.

First, semiconductor material 6 is introduced into the crucible 2. The he heater 3 heats the material 6, melting the same. A seed crystal is inserted into the molten material 6 in the crucible 2. The lifter 51 pulls up the seed crystal gradually at a prescribed speed. As the seed crystal is thus pulled up, the crystal gradually grows at the solid-liquid interface of the material. As a result, a large crystal 9 is obtained.

While the heater 3 is applying heat to the material 6, a heat convection takes place in the molten material 6. Nonetheless, the material 6 would not move in the crucible 2, because the superconducting coil 4 built in the cryostat 5 generates and applies magnetic fluxes 7 to the molten material 6. The crystal 9 therefore readily grows as it is pulled up from the crucible 2 in the axis 10 of the crucible 2 by means of the lifter 51.

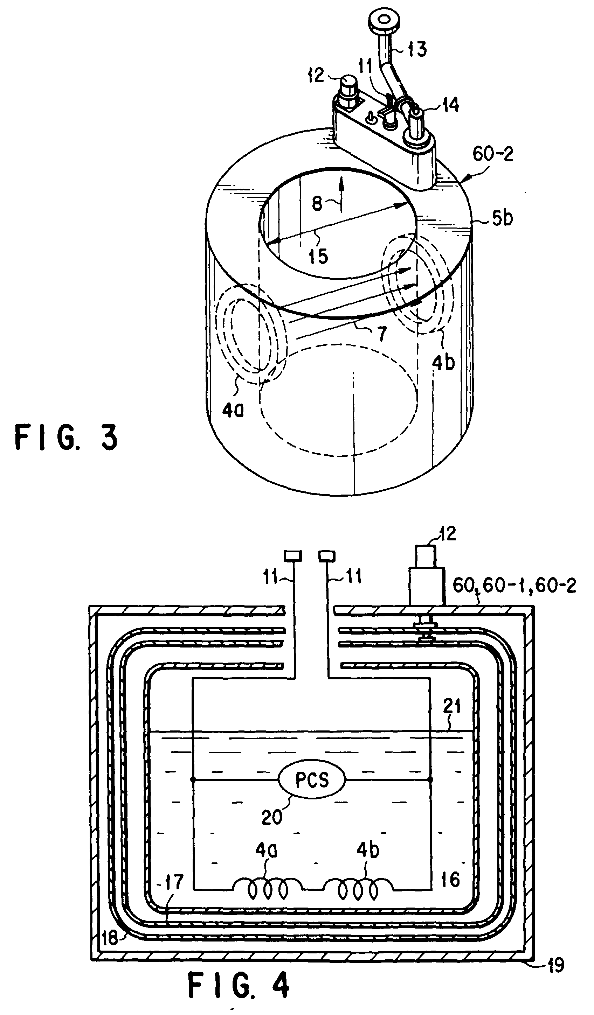

The magnetic field generator 60 (i.e., a superconducting magnet) may be of the type 60-1 shown in FIG. 2 or the type 60-2 shown in FIG. 3.

The magnetic field generator (superconducting magnet) 60-1 shown in FIG. 2 has a U-shaped cryostat 5a. Two superconducting coils 4a and 4b are built in the cryostat 5a, opposing each other. The field magnetic generator 60-1 has a current lead 11, a small-sized helium refrigerator 12, a gas exhaust pipe 13, and a service port (not shown). The current lead 11 supplies a current to both superconducting coils 4a and 4b. The helium refrigerator 12 cools the radiation shield (not shown) provided in the cryostat 5a. The gas exhaust pipe 13 releases helium gas from the cryostat 5a. The service port is provided to replenish helium gas in the refrigerator 12.

The magnetic field generator (superconducting magnet) 60-2 shown in FIG. 3 has a hollow cylindrical cryostat 5b. Two superconducting coils 4a and 4b are built in the cryostat 5b as in the generator 60-1 illustrated in FIG. 2. Like the magnetic field generator 60-1, the magnetic field generator 60-2 has a current lead 11, a small-sized helium refrigerator 12, a gas exhaust pipe 13, and a service port (not shown).

Both magnetic field generators 60-1 and 60-2 generates and apply a magnetic field in horizontal direction. In other words, they applies a magnetic field at right angles to the axis 10 of the crucible 2.

The magnetic field generator 60, either the generator 60-1 (FIG. 2) or the generator 60-2 (FIG. 3), will be described in greater detail, with reference to FIG. 4.

FIG. 4 is a schematic sectional view of the magnetic field generator 60, showing the cryostat 5 which contains two superconducting coils 4a and 4b. As shown in FIG. 4, the superconducting coils 4a and 4b are connected in series. The free end of the coil 4a and that of the coil 4b are connected to a current lead 11. When supplied with the same current through the lead 11, the coils 4a and 4b generate magnetic fields which have the same intensity and which extend in the same direction. A persistent current switch (PCS) 20 is connected in parallel to the superconducting coils 4a and 4b and, hence, in parallel to the current lead 11. Even after the switch 20 is turned off, stopping the supply of a current through the lead 11, a current keeps flowing perpetually through both superconducting coils 4a and 4b. The coils 4a and 4b therefore keep generating magnetic fields.

The superconducting coils 4a and 4b and the persistent current switch 20 are immersed in the refrigerant which is contained in a refrigerant container 16. The container 16 is sealed within a firs radiation shield 17, which in turn is sealed within a second radiation shield 18. The radiation shields 17 and 18 are maintained at different temperatures. Both radiation shields 17 and 18 are placed in a vacuum container 19, and their interior is thermally insulated. The helium refrigerator 12 cools the radiation shields 17 and 18, reducing the radiant heat emanating into the refrigerant container 16.

The superconducting coils 4a and 4b are Helmholtz coils and generate magnetic fluxes 7 as shown in FIGS. 2 and 3. The magnetic fluxes 7 form a magnetic field which extends in the horizontal direction and which is symmetrical with respect to the axis 10 of the crucible 2 (FIG. 1).

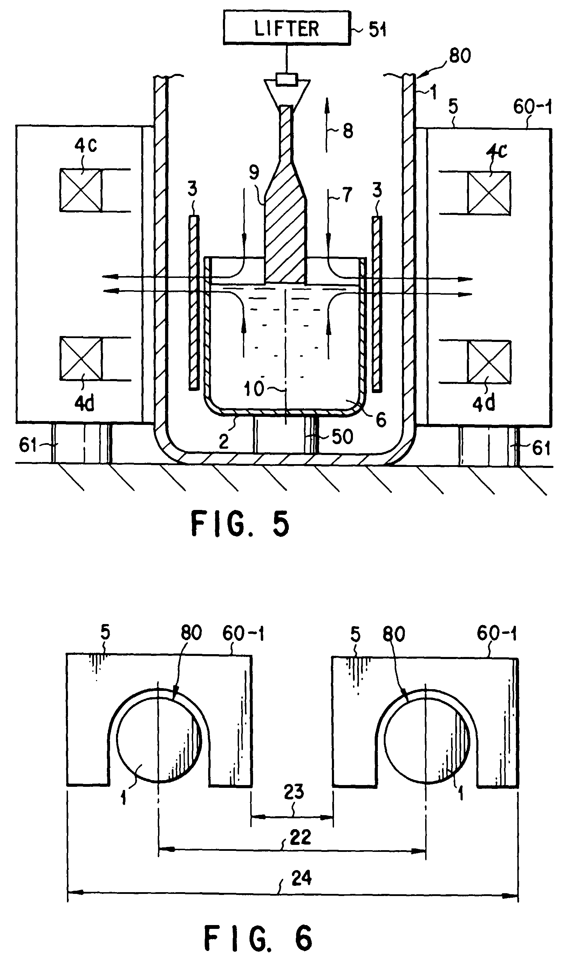

Another conventional MCZ system will be described, with reference to FIG. 5. The components similar or identical to those of the MCZ system shown in FIGS. 1 and 2 are designated at the same reference numerals in FIG. 5 and will not be described in detail.

As shown in FIG. 5, a magnetic field generator 60-1 has a cryostat 5 which contains two superconducting coils 4c and 4d, as in the MCZ system shown in FIGS. 1 and 2. The coils 4c and 4d are arranged concentrically, with their common axis extending in the direction 8 in which a crystal is pulled upwards. The magnetic fluxes 7 the coils 4c and 4d generate extend in the direction 8, too. The superconducting coils 4c and 4d are Cusp coils which generate cusp magnetic fields extending in the opposite directions. Having two Cusp coils, the magnetic field generator 60-1 functions as a Cusp magnet.

The coils 4c and 4d may be replaced by Helmholtz coils which generate magnetic fields extending in the same direction. If so, the generator 60-1 will function as a Helmholtz magnet. In general, Helmholtz coils are used in a magnetic field generator which generates a horizontal magnetic field, whereas Cusp coils are used in a magnetic field generator which generates a vertical magnetic field.

Either type of a magnetic field generator, described above, is disadvantageous in the following respects.
1. The size of the furnace body 1 depends on the size of the crystal 9 being pulled up. The bore space 15 (FIG. 2) in which the body 1 is provided can hardly be changed, because the vacuum container 19 contains any other components of the magnetic field generator 60. Hence, when a larger or small furnace body 1 is used, a new magnetic field generator must be made which has a bore space of a size appropriate for holding the new magnetic field generator.
2. To change the magnetic field generator 60 which is a Helmholtz magnet into a Cusp magnet, the coils 4a and 4b connected in series must be disconnected and then connected in a different fashion. Alternatively, an additional coil or additional superconducting coils must be connected to the coils 4a and 4b. In either case, it is difficult to change the Helmholtz magnet into a Cups magnet. It is equally difficult to change the magnetic field generator 60-1 shown in FIG. 5 which is a Cusp magnet, into a Helmholtz magnet.
3. With the magnetic field generator of FIG. 1 it is impossible to adjust the center of the magnetic field by changing the current flowing through the coil 4a or the coil 4b, or both. The generator which generates a horizontal magnetic field must therefore be positioned with high precision with respect to the lifter 51 so that the magnetic field may be symmetrical with respect to the axis 10 of the crucible 2.
   With the magnetic field generator of FIG. 5 it is impossible to move down the center of the magnetic field as the surface of the molten material 6 lowers while the lifter 51 is pulling the crystal 9 upwards. The magnetic field near the surface of the molten material 6 cannot serve to manufacture a crystal ingot which is uniform in quality.
4. The generator designed to generate a horizontal magnetic field cannot be modified into one which generates a vertical magnetic field. The generator 60-2 (FIG. 3) having a hollow cylindrical cryostat 5b, for example, needs to have not only the coils 4a and 4b, but also two more coils which generate a vertical magnetic field, so that it may be used to generate a vertical magnetic field, as well. The generator 60-2 will be larger and more expensive.
5. Two U-shaped cryostat 5 of the type shown in FIG. 2 may be arranged side by side and two furnace bodies 1 may be located at a pitch 22, as is shown in FIG. 6. If this is the case, the space 24 the cryostats 5 occupy cannot reduced any more once the distance 23 between the cryostats 5 is decreased to nil.

The object of the present invention is to provide an MCZ system having a magnetic field generator whose bore size can be easily changed, which can function as a Helmholtz magnet and a Cusp magnet, which can generate a horizontal magnetic field and a vertical magnetic field, which can easily move the center of either type of a magnetic field, and which can be installed in a small space.

According to the invention, there is provided a magnetic-field applied Czochralski crystal growth system comprising at least one growing furnace for containing molten semiconductor material, pulling means for pulling a crystal from the molten semiconductor material in a predetermined direction, and a magnetic field generator for generating a magnetic field to be applied to the molten semiconductor material, characterized in that the magnetic field generator comprises a plurality of magnet units and a coupling mechanism coupling the magnet units together such that the at least one growing furnace is located between the magnet units.

The bore space between any adjacent magnet units can be changed merely by replacing the coupling mechanism with another having a different length or by adjusting the length of the coupling mechanism. Thus, many magnetic field generators need not be made which have bore spaces of different sizes for accommodating growing furnaces of different sizes.

Further, the magnet units need not be positioned precisely with respect to the growing furnace, because the center and distribution of the magnetic field can be easily changed.

Moreover, the system can prepare high-quality crystal ingots because the intensity of the magnetic field applied to the molten material can be adjusted in accordance with changes in the surface level of the semiconductor molten material.

This invention can be more fully understood from the following detailed description when taken in conjunction with the accompanying drawings, in which:
FIG. 1 is a vertical sectional view of a conventional MCZ system;
FIG. 2 is a perspective view of a magnetic field generator which my be incorporated in the MCZ system of FIG. 1;
FIG. 3 is a perspective view of another type of a magnetic field generator which my be incorporated in the MCZ system of FIG. 1;
FIG. 4 is a schematic sectional view showing one of the magnetic field generators illustrated in FIGS. 2 and 3;
FIG. 5 is a vertical sectional view of another type of a conventional MCZ system;
FIG. 6 is a diagram explaining the disadvantages of the magnetic field generator incorporated in the conventional MCZ systems;

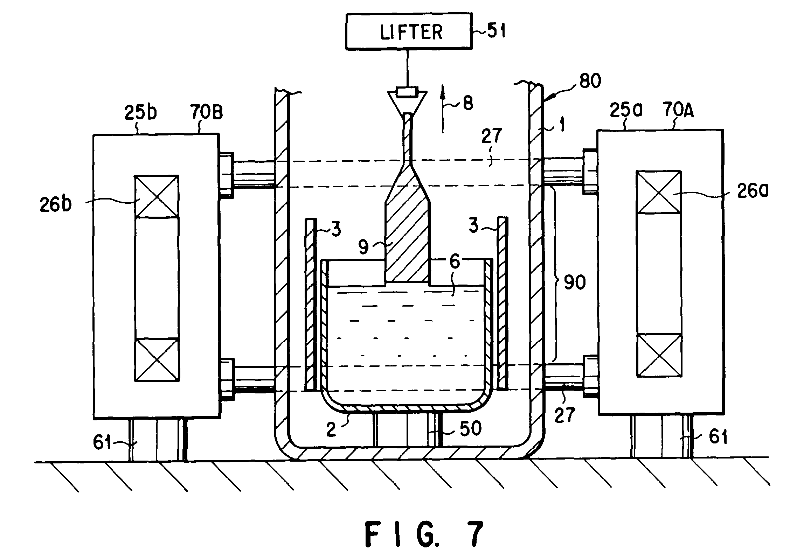

FIG. 7 is a sectional view of an MCZ system according to a first embodiment of the present invention;

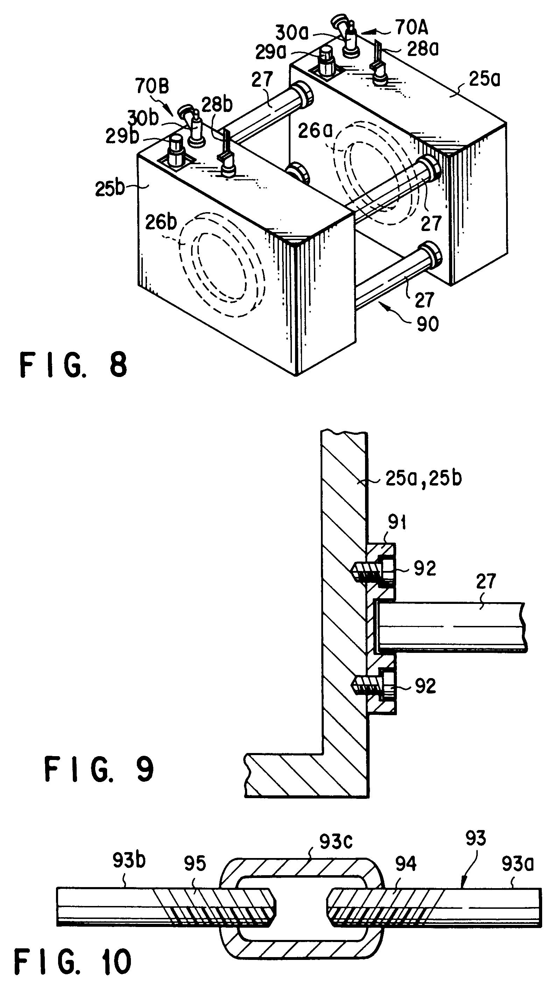

FIG. 8 is a perspective view of the magnetic field generator incorporated in the MCZ system illustrated in FIG. 7;
FIG. 9 is a diagram showing one type of a coupling mechanism which may be used in the MCZ system shown in FIG. 7;
FIG. 10 is a diagram showing another type of a coupling mechanism which may be used in the MCZ system of FIG. 7;

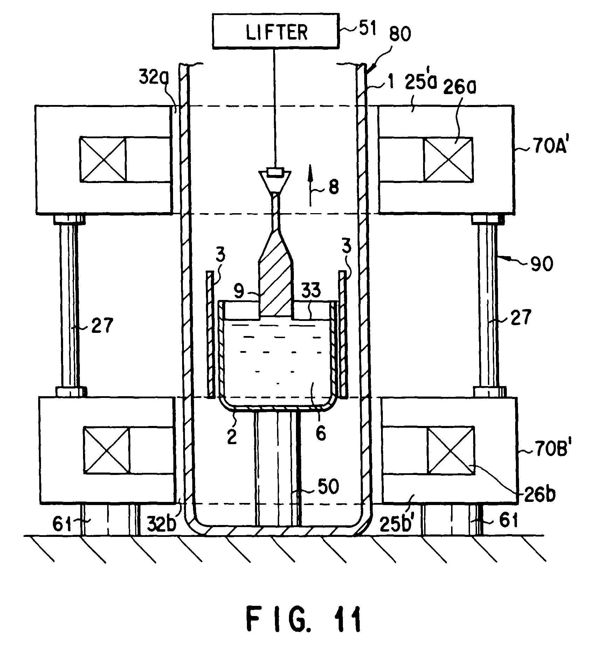

FIG. 11 is a sectional view of an MCZ system according to a second embodiment of the invention;

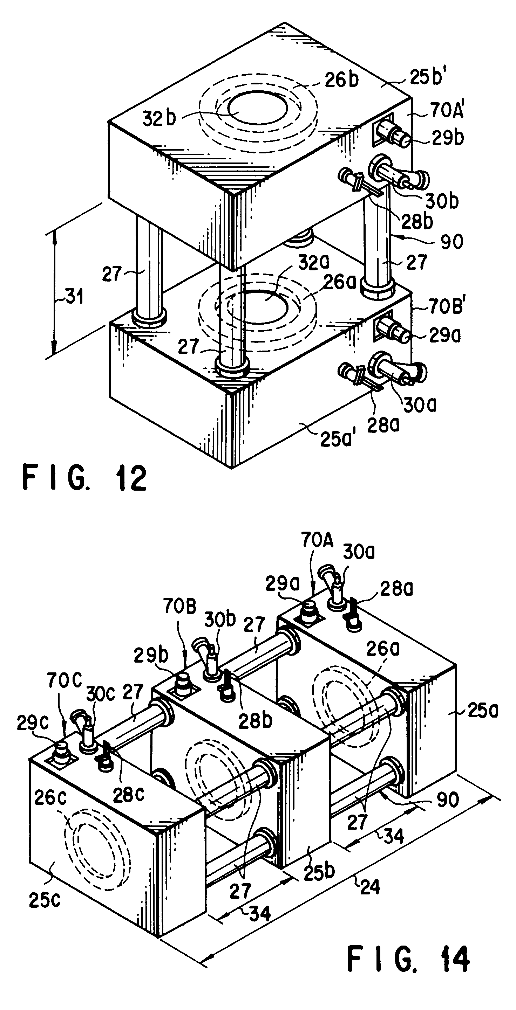

FIG. 12 is a perspective view of the magnetic field generator incorporated in the MCZ system of FIG. 11;

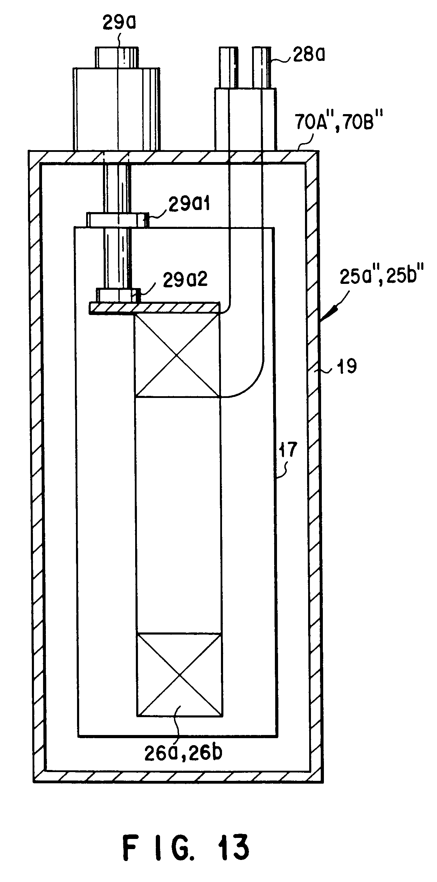

FIG. 13 is a sectional view of one of two identical magnet units incorporated in an MCZ system according to a third embodiment of this invention; and
FIG. 14 is a perspective view of the magnet units incorporated in an MCZ system according to a fourth embodiment of the invention.

An MCZ system according to the first embodiment of the present invention will be described, with reference to FIGS. 7 and 8.

As shown in FIG. 7, the MCZ system comprises a growing furnace 80 and two magnetic units 70A and 70B. Semiconductor material 6 is melted in the growing furnace 80, so that a crystal may be pulled upwards from the molten semiconductor material. The magnetic units 70A and 70B are used as magnetic field generators, for generating magnetic fields to be applied to the molten material 6 in the growing furnace 80.

The growing furnace 80 is identical to those used in the conventional MCZ systems. It includes a furnace body 1, a crucible 2 provided in the body 1, a heater 3 for heating the material 6 in the crucible 2, a crucible support mechanism 50 supporting the crucible 2, and a lifter 51 for pulling up a crystal from the molten material 6. The mechanism 50 and the lifter 51 rotate relative to each other, whereby the crystal and crucible 2 are rotated relative to each other. The magnet units 70A and 70B are mounted on supports 61.

The MCZ system is characterized by the magnet units 70A and 70B. The units 70A and 70 are coupled together by a coupling mechanism 90. The growing furnace 80 is located between the first magnet unit 70A and the second magnet unit 70B.

How a crystal ingot is made in the MCZ system shown in FIG. 7 will be explained.

First, semiconductor material 6 is introduced into the crucible 2. The he heater 3 heats the material 6, melting the same. A seed crystal is inserted into the molten material 6 in the crucible 2. The lifter 51 pulls up the seed crystal gradually at a prescribed speed. As the seed crystal is thus pulled up, the crystal gradually grows at the solid-liquid interface of the material. As a result, a large crystal 9 is obtained.

While the heater 3 is applying heat to the material 6, a heat convection takes place in the molten material 6. Nonetheless, the material 6 would not move in the crucible 2, because the magnet units 70A and 70B generate and apply magnetic fluxes to the molten material 6. The crystal 9 therefore readily grows as it is pulled up from the crucible 2 in the axis 10 of the crucible 2 by means of the lifter 51.

The magnet units 70A and 70B will be described in detail.

As shown in FIG. 8, the first magnet unit 70A has a cryostat 25a, and the second magnet unit 70B has a cryostat 25b. The cryostats 25a and 24b are identical in structure. Superconducting coils 26a and 26b are built in the cryostats 25a and 25b, respectively. The coupling mechanism 90 couples the cryostats 25a and 25b so that the distance between the cryostats 25a and 25b may be adjusted.

The coupling mechanism 90 is of either the type shown in FIG. 9 or the type shown in FIG. 10. The mechanism shown in FIG. 9 is a fixed-length type. The mechanism shown in FIG. 10 is a variable-length type.

The fixed-length coupling mechanism shown in FIG. 9 comprises four support rods 27. Two flanges 91 are connected to the ends of each support rod 27, respectively, by mechanical means or metallurgical means such as welding. The first flange 91 are fastened to the first cryostat 25a by bolts 92. Similarly, the second flange 91 are fastened to the second cryostat 25b by bolts 92.

The variable-length coupling mechanism shown in FIG. 10 comprises four variable-length support rods 93 which are turnbuckles. Each support rod 93 is composed of two rods 93a and 93b and a ring-shaped coupling member 93c. The first rod 93a has a right-handed screw 94 on one end portion. The second rod 93b has a left-handed screw 95 on one end portion. The coupling member 93c has two screw holes in its end, respectively. The screws 94 and 95 on the rods 93a and 93b are set respectively in the screw holes of the coupling member 93c. The rods 93a and 93b are fastened to the cryostats 25a and 25b, respectively, by metallurgical means such as welding or mechanical means using flanges of the type shown in FIG. 9.

The support rods 27 of the fixed-length coupling mechanism (FIG. 9) may be replaced by longer or shorter ones. The bore space between the cryostats 25a and 25b can be then changed to a desired size. The support rods 93 of the variable-length coupling mechanism (FIG. 10) may be lengthened or shortened, merely by turning the ring-shaped coupling members 93. As a result, the bore space between the cryostats 25a and 25b can be varied to a desired size.

As seen from FIG. 8, current leads 28a and 28b are connected to the cryostats 25a and 25b, respectively. The first cryostat 25a contains a small-sized helium refrigerator 29a and has a service port 30a. Similarly, the second cryostat 25b contains a small-sized helium refrigerator 29b and has a service port 30b. The first refrigerator 29a cools the radiation shields (not shown) provided in the first cryostat 25a. Through the service port 30a, liquid helium is supplied into the first cryostat 25a and helium gas is discharged therefrom. The second refrigerator 29b cools the radiation shields (not shown) provided in the second cryostat 25b. Through the service port 30b, liquid helium is supplied into the second cryostat 25b and helium gas is discharged therefrom.

As shown in FIG. 7, the cryostats 25a and 25b are arranged side by side, set apart from each other by the support rods 27 of the same length. Therefore, a space is provided between the cryostats 25a and 25b. In this space the growing furnace 80 is located as illustrated in FIG. 7.

In the MCZ system shown in FIGS. 7 and 8, it may be necessary to replace the growing furnace 80 with a larger one or a smaller one. If so, the support rods 27 of the coupling mechanism 90 are replaced with longer ones or shorter ones, thereby enlarging or reducing the space between the cryostats. The larger or smaller growing furnace can be installed in the space thus changed in size.

The superconducting coils 26a and 26b built in the cryostats 25a and 25b are connected to the current leads 28a and 28b, respectively. Hence, the currents supplied to the coils 26a and 26b may be respectively increased and decreased easily from the standard value by an external power-supply unit. In this case, the center of the magnetic field the coils 26a and 26b generate moves to the left, or toward the coil 26b to which the smaller current is supplied.

Furthermore, the direction of the magnetic field generated by one of the coils (the coil 26a or the coil 26b) can be changed by switching the polarities of the two terminals of the current lead connected to the coil (the lead 28a or the lead 28b). Hence, the combination of the magnet units 70A and 70B can work as a Helmholtz magnet and a Cusp magnet, and the switching from the Helmholtz magnet to the Cusp magnet, and vice versa, can be easily achieved.

An MCZ system according to the second embodiment of the invention will be described, with reference to FIGS. 11 and 12. The components similar or identical to those of the MCZ system shown in FIGS. 7 and 8 are designated at the same reference numerals in FIGS. 11 and 12, and will not be described in detail.

The second embodiment differs from the first embodiment in two respects only. First, two magnet units 70A' and 70B' are positioned one above the other and concentrically, in axial alignment with the axis of the crucible 2 in which the crystal 9 is upped upwards. Second, the magnet units 70A' and 70B' are spaced apart and coupled together by a coupling mechanism 90, more precisely by support rods 27. The components other than the magnet units 70A' and 70B' and the coupling mechanism 90 are positioned in the same way as in the first embodiment (FIG. 7).

As seen from FIGS. 11 and 12, the cryostat 25a of the first magnet unit 70A' has a through hole 32a, and the cryostat 25b of the second magnet unit 70B' has a through hole 32b. The holes 32a and 32b are coaxial with each other and extend vertically. The furnace body 1 stands upright, extending through the holes 32a and 32b of the cryostats 25a and 25b. The superconducting coils 26a and 26b provided in the cryostats 25a and 25b, respectively, generate a magnetic field which extends in the direction of arrow 8 in which the crystal 9 is pulled upwards.

Like the magnet units 70A and 70B incorporated in the first embodiment, the combination of the magnet units 70A' and 70B' can function as a Helmholtz magnet and a Cusp magnet. Whether the center of the magnetic field lies on the surface 33 of the molten material 6 in the crucible 2 influences the growth of the crystal 9. Nevertheless, the center of the magnetic field can be moved to follow the surface 33, merely by supplying different currents to the superconducting coils 26a and 26b.

An MCZ system according to the third embodiment of the invention will be described, with reference to FIG. 13.

The third embodiment is identical to the first embodiment (FIGS. 7 and 8), except that no service ports are provided to supply liquid helium or to discharge helium gas. The third embodiment has two magnet units 70A'' and 70B'' in which the superconducting coils 26a and 26b are cooled by small-sized helium refrigerators 29a and 29b and thereby maintained in superconducting state. The third embodiment has neither a refrigerant container. The superconducting coils 26a and 26b are provided in cryostats 25a'' and 25b'', respectively.

The magnet units 70A'' and 70B'' are identical in structure, and only the first magnetic unit 70A'' will be described with reference to FIG. 13. As shown in FIG. 13, the coil 26a is sealed by a radiation shield 17 provided in the vacuum container 19 of the cryostat 25b''. A current lead 28a is mounted on the cryostat 25a''. A current is supplied via the lead 28a to the superconducting coil 26a. The helium refrigerator 29a has two cooling stages 29a1 and 29b2. The first cooling state 29a1 cools the superconducting coil 26a, while the second cooling state 29a2 cools the radiation shield 17.

Both magnetic units 70A'' and 70B'' are superconducting magnets which are directly cooled. That is, the unit 70A'' is cooled directly by the refrigerator 29a, and the unit 70B'' is cooled directly by the refrigerator 29b. So cooled, the magnet units 70A'' and 70B'' can remain in superconducting state, without introducing a refrigerant, e.g., liquid helium, into the cryostat 25a'' or the cryostat 25b''. The operating cost of the third embodiment can be reduced by the cost for replenishing a refrigerant in the cryostats and discharging the used refrigerant therefrom.

An MCZ system according to the fourth embodiment of the invention will be described, with reference to FIG. 14.

As seen from FIG. 14, this MCZ system has three magnet units 70A, 70B and 70C. The magnetic units 70A, 70B and 70C have cryostats 25a, 25b and 25c, respectively. The cryostats 25a, 25b and 25c are arranged side by side and coupled to one another by eight support rods 27. Though not shown in FIG. 14, the fourth embodiment has two growing furnaces identical to the furnace 80 shown in FIG. 7. The first growing furnace is located in the space 34 between the first cryostat 25a and the second cryostat 25b. The second growing furnace is located in the space between the second cryostat 25b and the third cryostat 25c.

The conventional MCZ system shown in FIG. 6, which has two cryostats 5, needs to have four superconducting coils in total. By contrast, the fourth embodiment of the present invention has only three superconducting coils, which are provided in the cryostats 25a, 25b and 25c, respectively. Obviously, the space 24 which the three cryostats 25a, 25b and 25c, each containing one superconducting coil, occupy is smaller than the space 24 which the two cryostats 5, each containing two superconducting coils. In addition, the fourth embodiment which has three superconducting coils can be manufactured at a lower cost than the conventional MCZ system (FIG. 6) which has four superconducting coils.

The fourth embodiment shown in FIG. 14 comprises three cryostats and two growing furnaces. If one more growing furnace is used, it suffices to add one cryostat. Furthermore, the fourth embodiment needs only N + 1 superconducting coils, where N is the number of growing furnaces used, whereas the conventional MCZ system of FIG. 6 needs as many as N × 2 superconducting coils. If either MCZ system has ten growing furnaces, the fourth embodiment (FIG. 14) has nine superconducting coils less than the conventional MCZ system (FIG. 6).

The fourth embodiment may have directly cooled superconducting coils of the type shown in FIG. 13. In this case, the fourth embodiment is simple enough to be mass-produced and hence can be manufactured at a lower cost.

As may be understood from the above, the MCZ systems according to the present invention is advantageous in the following respects.

Since the space between the magnet units can be easily changed in accordance with the size of the growing furnace to be located in the space, a magnetic field generator need not be made which has a bore space suitable to accommodate the growing furnace. Further, the magnet units need not be positioned precisely with respect to the growing furnace, because the center and distribution of the magnetic field can be easily changed. Still further, the MCZ systems can prepare high-quality crystal ingots because the intensity of the magnetic field applied to the molten material can be adjusted in accordance with changes in the surface level of the molten material.

Moreover, the pair of superconducting coils can generate both a horizontal magnetic field and a vertical magnetic field. In addition, the pair of the superconducting coils can constitute a Helmholtz magnet and a Cusp magnet.

As described above, the magnet units are cooled directly by the helium refrigerators, the refrigerant need not be replenished in the magnet units and the used refrigerant need to be discharged therefrom. The operating cost of the MCZ system can therefore be reduced. For the same reason, the MCZ system as a whole is more simple in structure, can be more easily mass-produced and, hence, can be manufactured at a lower cost.

Furthermore, the space for accommodating the growing furnace can be reduced in the MCZ systems according to the present invention.

## Claims

1. A magnetic-field applied Czochralski crystal growth system comprising at least one growing furnace (80) for containing molten semiconductor material, pulling means for pulling a crystal from the molten semiconductor material in a predetermined direction, and a magnetic field generator (70A, 70B, 70C; 70A', 70B') for generating a magnetic field to be applied to the molten semiconductor material,
characterized in that said magnetic field generator comprises a plurality of magnet units (70A, 70B, 70C; 70A', 70B') and a coupling mechanism (90) coupling said magnet units (70A, 70B, 70C; 70A', 70B') together such that said at least one growing furnace (80) is located between said magnet units (70A, 70B, 70C; 70A', 70B').

2. A system according to claim 1, characterized in that each of said magnet units (70A, 70B, 70C; 70A', 70B') comprises means for generating a magnetic field which extends perpendicular to said predetermined direction.

3. A system according to claim 1, characterized in that each of said magnet units (70A, 70B, 70C; 70A', 70B') comprises means for generating a magnetic field which extends in said predetermined direction.

4. A system according to claim 1, characterized in that said coupling mechanism (90) includes fixed-length support rods (27).

5. A system according to claim 1, characterized in that said coupling mechanism (90) includes variable-length support rods (27).

6. A system according to claim 1, characterized in that each of said magnetic units (70A, 70B, 70C; 70A', 70B') has current-supplying means for supplying currents of different values.

7. A system according to claim 1, characterized in that said magnetic units (70A, 70B, 70C; 70A', 70B') have means for generating magnetic fields which extend in the same direction and which form a Helmholtz magnetic field.

8. A system according to claim 1, characterized in that said magnetic units (70A, 70B, 70C; 70A', 70B') have means for generating magnetic fields which extend in the opposite directions and which form a Cups magnetic field.

9. A system according to claim 1, characterized in that each of said magnetic units (70A, 70B, 70C; 70A', 70B') is a direct-cooled superconducting magnet and comprises vacuum containers (25a, 25b), superconducting coils (26a, 26b) provided in the vacuum containers (25a, 25b), respectively, and refrigerators (29a, 29b) for directly cooling the superconducting coils (26a, 26b), respectively, thereby to set the superconducting coils (26a, 26b) in superconducting state.

10. A system according to claim 9, characterized in that each of said magnetic units (70A, 70B, 70C; 70A', 70B') further comprises radiation shields (17) provided in said vacuum containers (25a, 25b), respectively, and cooled by said refrigerators (29a, 29b).

11. A system according to claim 1, characterized in that said coupling mechanism (90) comprises means connecting said magnetic units (70A, 70B, 70C; 70A', 70B') in series.

12. A system according to claim 1, characterized in that each of said magnetic units (70A, 70B, 70C; 70A', 70B') is an indirect-cooled superconducting magnet and comprises superconducting coils (26a, 26b) which are cooled with a refrigerant and which are thereby set in superconducting state.

13. A system according to claim 1, characterized in that said at least one growing furnace (80) comprises a furnace body (1), a crucible (2) provided in the furnace body (1), for containing semiconductor material, a heater (3) for heating the semiconductor material in the crucible (2), and a mechanism (50, 51) for growing and pulling up the crystal.

14. A system according to claim 13, characterized in that said mechanism (50, 51) for growing and pulling up the crystal includes means for rotating the crystal and said crucible relative to each other.

15. A system according to claim 1, characterized in that at least one of said magnet units (70A, 70B, 70C; 70A', 70B') has holes (32a, 32b) in which said at least one growing furnace (80) is provided.
